# EUROPÄISCHE PATENTSCHRIFT

(11) **EP 0 959 652 B1**
(45) Veröffentlichungstag und Bekanntmachung des Hinweises auf die Patenterteilung: **21.09.2005**
(21) Anmeldenummer: 99104542.8
(22) Anmeldetag: 06.03.1999
(51) Int. Cl.: H05K 9/00

(54) **Elektronischer Schaltkreis mit einem hochfrequenzbedämpfenden Schirmgehäuse**
Electronic circuit with a high-frequency damping casing
Circuit de commutation électronique avec boîte d'écran HF

(30) Priorität: 22.05.1998 DE 19822888
(43) Veröffentlichungstag der Anmeldung: 24.11.1999
(73) Patentinhaber: SIEMENS AKTIENGESELLSCHAFT, 80333 München (DE)
(72) Erfinder: Barz, Herbert, 65439 Flörsheim (DE)

(56) Entgegenhaltungen:
- EP-A- 0 438 056
- US-A- 5 099 396

## Beschreibung

Die Erfindung bezieht sich auf einen elektronischen Schaltkreis, bestehend aus elektrischen und/oder elektronischen Bauelementen und deren Verbindungsleitungen auf einer Leiterplatte, wobei ein Schirmgehäuse den elektronischen Schaltkreis zur Verhinderung von Störungen, die auf den elektronischen Schaltkreis einwirken und die durch den elektronischen Schaltkreis hervorgerufen werden, hochfrequenzbedämpfend umschließt, wobei der Schaltkreis aus dem Schirmgehäuse nach außen führende Anschlußleitungen aufweist. Dieser Schaltkreis ist vorgesehen insbesondere zum Einbau auf eine Grundplatte in einem Kraftfahrzeugkombinationsinstrument, mit dem verschiedene Anzeigeinstrumente, Anzeigefelder, Kontroll- und Warnleuchten sowie die dazu erforderlichen elektrischen und elektronischen Ausrüstungsteile in einem gemeinsamen Gehäuse angeordnet und durch eine gemeinsame Sichtscheibe abgedeckt sind.

Aus dem Stand der Technik ist eine Abschirmung bekannt, bei der der Schaltkreis vollständig von einem Abschirmgehäuse umgeben ist und Kontaktmittel in Form von Kontaktfedern den Schaltkreis mit einer Grundplatte verbinden, die alle für die Funktion des Kombinationsinstruments erforderlichen sonstigen aktiven und passiven Schaltelemente, Leiterbahnen, Steckverbinder und Anschlußpunkte enthält. Hierbei ist der Schaltkreis auf einer Leiterplatte untergebracht und über verschiedenförmige Kontaktfedern, die durch das Abschirmgehäuse geführt sind, mit der Grundplatte verbunden. Nachteilig bei dieser Abschirmung ist es, daß verschiedenförmige Kontaktmittel benötigt werden. Weiterhin läßt sich das bekannte Abschirmgehäuse nur von Hand montieren.

Aus der vorangemeldeten DE 196 511 87.0 ist es bereits bekannt, einen auf einer Leiterplatte angeordneten elektrischen Schaltkreis mit einem Schirmgehäuse zu umgeben und die Anschlußleitungen auf der Leiterplatte nach außen zu führen, und dort mit Anschlußmitteln zur elektrischen Verbindung mit einem weiteren Schaltkreis auf einer Grundplatte zu verbinden. Das Schirmgehäuse besteht dabei aus einer Schirmgehäusedose, die auf die Leiterplatte aufgesetzt ist, und einen Schirmgehäusedeckel, der auf der Rückseite der Leiterplatte die Schirmgehäusedose schließt, so daß der elektrische Schaltkreis allseitig von dem Schirmgehäuse umgeben ist. Nachteilig bei dieser Abschirmung ist es, daß nur eine Seite der Leiterplatte mit elektrischen Bauteilen bestückbar ist und so bei Schaltkreisen, die eine größere Anzahl von elektrischen und/oder elektronischen Bauteilen benötigen, eine entsprechend große Leiterplatte benötigt wird.

Aus EP-A-0438056 ist ferner einer Schaltkreis gemäß dem Oberbegriff des Anspruchs 1 bekannt.

Aufgabe der Erfindung ist es daher, eine Abschirmung für einen elektrischen Schaltkreis anzugeben, die die Montierbarkeit des Schaltkreises samt Schirmgehäuse auf der Grundplatte verbessert. Diese Aufgabe wird dadurch gelöst daß das Schirmgehäuse Positionierhilfen zum Positionieren des Schaltkreises auf der Grundplatte aufweist.

Weiterhin können diese Positionierhilfen so ausgestattet sein, daß sie der mechanischen Abstützung dienen, so daß der Schaltkreis samt Schirmgehäuse noch besser auf einer Grundplatte oberflächenmontierbar wird.

Dadurch, daß die Anschlußmittel mit den Anschlußleitungen auf der Oberseite und der Unterseite der Leiterplatte verbunden sind, sind Bauteile auf der Oberseite und Unterseite der Leiterplatte ohne Durckkontaktierung durch die Leiterplatte miteinander verbindbar.

Durch Verwendung von Anschlußmitteln zur Oberflächenmontage des Schaltkreises auf eine Grundplatte entfallen auf der Grundplatte die sonst erforderlichen Bohrungen zur Durchsteckmontage. Hierdurch werden die Montage bzw. Plazierung preiswerter und die Grundplatte stabiler und es ist möglich, auf der Grundplatte unterhalb des elektrischen Schaltkreises elektrische Bauteile zu montieren, da Raum für Leiterbahnen unterhalb der Grundplatte vorhanden ist. Auch ist es z.B. möglich, auf der Grundplatte auf der dem Schaltkreis gegenüberliegenden Seite Bauteile wie z.B. Leuchtdioden (LED's) vorzusehen und den Raum zwischen dem Schaltkreis und der Grundplatte mit einer Kühlfläche oder Kühlkörper auf der Grundplatte zu versehen.

Die Erfindung wird nachfolgend für ein besonders bevorzugtes Beispiel anhand der Figuren näher erläutert. Es zeigen
- Figur 1:: eine Ansicht und einen Teilschnitt eines Ausführungsbeispiels des erfindungsgemäßen Schaltkreises auf einer Grundplatte,
- Figur 2:: Ansicht A aus Figur 1,
- Figur 3:: einen Teilschnitt einer abgewandelten Ausführungsform des erfindungsgemäßen Schaltkreises aus Figur 1,
- Figur 4:: die Aufsicht auf eine bevorzugte Ausführungsform einer Schirmgehäusedose,
- Figur 5:: die Ansicht B der Schirmgehäusedose aus Figur 4,
- Figur 6:: die Ansicht C der Schirmgehäusedose aus Figur 4,
- Figur 7:: die Aufsicht einer Ausführungsform eines Schirmgehäusedeckels, passend zu der Schirmgehäusedose aus Figur 4,
- Figur 8:: Ansicht D und einen Teilschnitt des Schirmgehäusedeckels aus Figur 7,
- Figur 9:: Ansicht E und einen Teilschnitt des Schirmgehäusedeckels aus Figur 7.

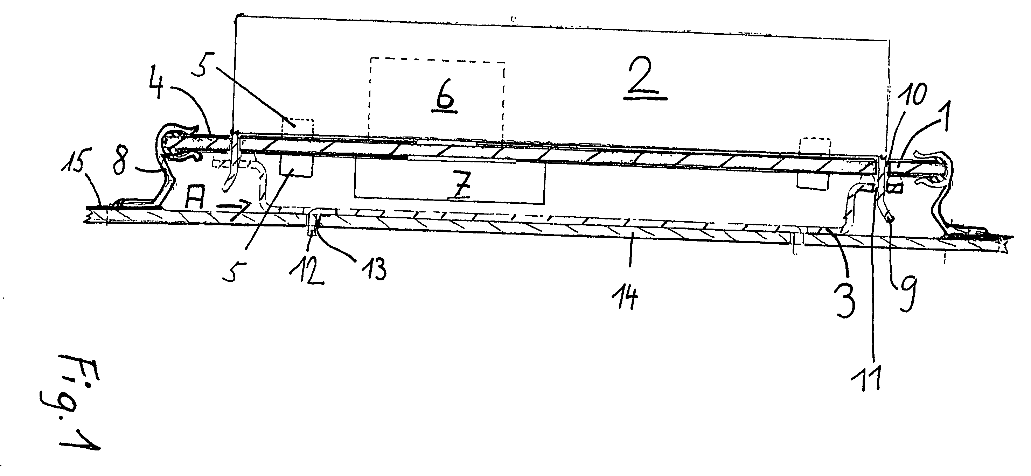

Das Ausführungsbeispiel des erfindungsgemäßen Schaltkreises in Figur 1 weist eine Leiterplatte 1 auf, die größtenteils von dem Schirmgehäuse bestehend aus Schirmgehäusedose 2 und Schirmgehäusedeckel 3 umgeben ist. Auf der Leiterplatte 1 sind Leiterbahnen 4 angebracht, die elektrische bzw. elektronische Bauteile untereinander verbinden, von denen die Bauteile 5, 6, 7 beispielhaft dargestellt sind. Weiterhin verbinden die Leiterbahnen 4 die Bauteile 5 mit den Anschlußmitteln in Form von Kontaktfedern 8, wobei die Leiterbahnen 4 zwischen der Leiterplatte 1 und dem Schirmgehäuse 2, 3 hindurchgeführt werden. Das Bauteil 5 ist besonders bevorzugt ein Kondensator, der die Leiterbahn 4 wechselstrommäßig über eine nicht dargestellte elektrisch leitende Verbindung mit der Schirmgehäusedose 2 verbindet.

Die Schirmgehäusedose 2 weist Biegelaschen 9 auf, die durch Öffnungen 10 in der Leiterplatte 1 und Öffnungen 11 im Schirmgehäusedeckel 3 geführt sind. Die Biegelaschen 9 sind nach dem Austritt aus den Öffnungen 11 im Schirmgehäusedeckel 3 gebogen, so daß der Schirmgehäusedeckel 3 gegen die Leiterplatte 1 gepreßt wird und so das Schirmgehäuse 2, 3 fest mit der Leiterplatte 1 verbunden ist. Der Schirmgehäusedeckel 3 weist vorteilhafterweise Positionierhilfen 12 auf, die in Öffnungen 13 der Grundplatte 17 ragen.

Die Kontaktfedern 8 sind außerdem über Lötverbindungen mit Leiterbahnen 15 auf der Grundplatte 14 verbunden.

Figur 2 zeigt eine besonders bevorzugte Ausführungsform der Positionierhilfen 12. Diese weisen einen breiteren Teil 16 auf, der nicht in die Öffnungen 13 der Grundplatte 14 paßt, so daß sich zwischen dem Schirmgehäusedeckel 3 und der Grundplatte 14 ein Luftspalt 17 bildet. Hierdurch werden unterschiedliche Wärmeausdehnungen zwischen der Grundplatte 14 und der Leiterplatte 1 besser ausgeglichen und die Lötverbindungen der Kontaktfedern 8 auf der Grundplatte 14 weniger belastet. Die Positionierhilfe 12 ist vorteilhafterweise an ihrer dem Schirmgehäusedeckel 3 abgewandten Seite abgerundet. Hierdurch läßt sie sich bei der Montage des Schaltkreises auf die Grundplatte 14 noch einfacher in die Öffnungen 13 der Grundplatte 14 einführen.

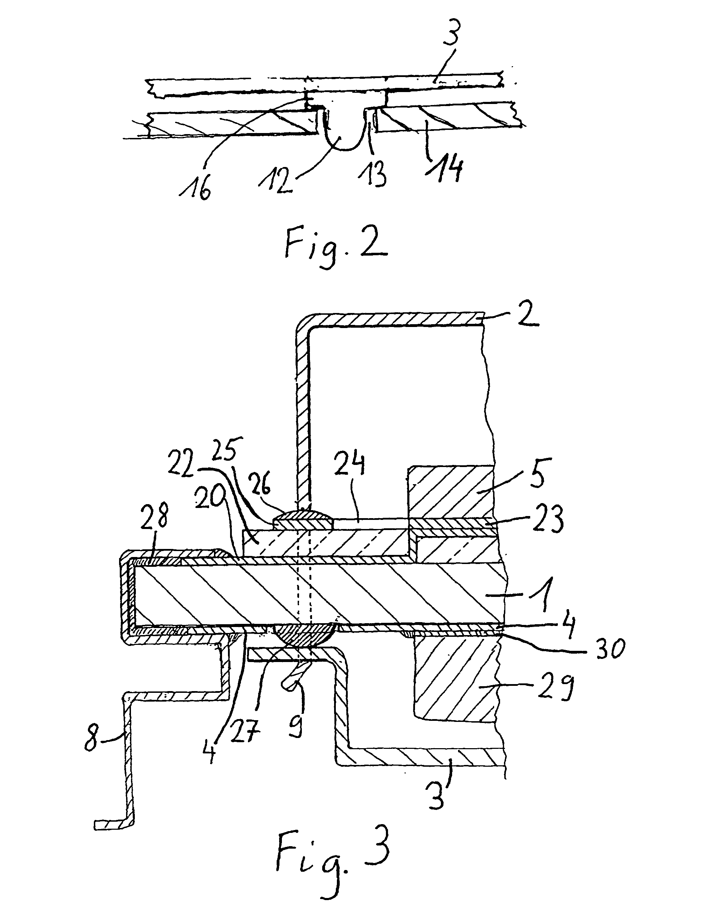

In Figur 3 weist die Leiterplatte 1 auf ihrer oberen Seite eine mehrlagige Leiterbahnschicht (Multilayer) auf, wovon die Leiterbahnen 20, 21 und die Isolierschicht 22 dargestellt sind. Auf der Unterseite der Leiterplatte 1 ist eine einlagige Leiterbahnschicht mit der Leiterbahn 4 dargestellt. Es ist jedoch auch hier ein Multilayer möglich. Die Leiterbahn 20 verbindet die Kontaktfeder 8 mit dem ersten Anschlußpin 23 des Kondensators 5. Der Kondensator 5 ist über seinen nicht dargestellten zweiten Anschlußpin über eine Leiterbahn 24, eine Masseringleitung 25 und einen Löthöcker 26 mit der Schirmgehäusedose 1 elektrisch leitend verbunden. Durch das Umbiegen der Biegelasche 9 wird die Schirmgehäusedose 1 auf den Löthöcker 26 und der Schirmgehäusedeckel 3 auf einen Löthöcker 27 gepreßt. Ein Kondensator 29 ist über einen ersten Anschlußpin 30 mit der Leiterbahn 4 verbunden und über einen zweiten nicht dargestellten Anschlußpin und eine nicht dargestellte Leitung mit dem Löthöcker 27. Die Leiterbahn 4 ist um den Löthöcker 27 herumgeführt, so daß sie mit diesem nicht verbunden ist.

Die Kontaktfeder 8 weist in Figur 3 an der Leiterplatte 1 eine doppel-U-förmige Gestalt auf. Durch das obere U kann die Kontaktfeder auf die Leiterplatte 1 geklemmt werden, bevor sie mittels Lötmasse 28 mit den Leiterbahnen 4, 20 dauerhaft elektrisch leitend verbunden wird. Das zweite U der Kontaktfeder 8 bewirkt eine besondere Elastizität der Kontaktfeder 8, so daß bei unterschiedlichen Wärmeausdehnungen von Leiterplatte 1 und der in Figur 3 nicht dargestellten Grundplatte die Beanspruchungen an den Lötstellen nicht zu groß werden.

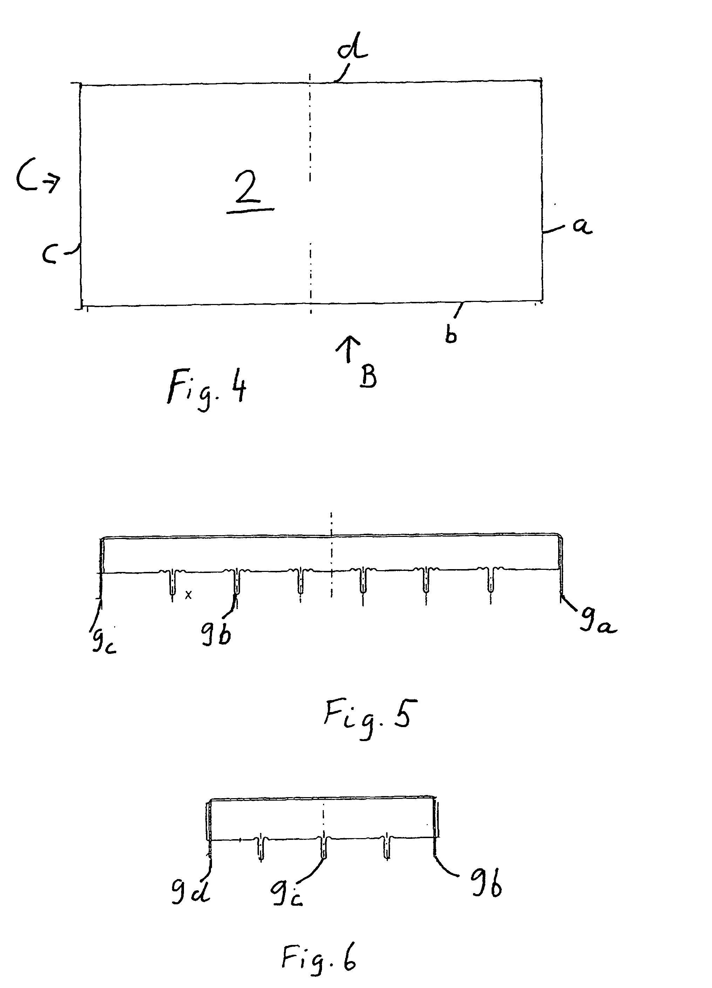

In Figur 4 weist die Schirmgehäusedose 2 vier Seiten a), b), c), d) auf.

Figur 5 zeigt 6 Biegelaschen 9b der Seite b) und je eine Biegelasche 9a, 9c der Seiten a) bzw. c).

Figur 6 zeigt drei Biegelaschen 9c der Seite c) und je eine Biegelasche 9d, 9a der Seiten d) bzw. a). An den Unterseiten der Seiten b) und d) sind neben den Biegelaschen 9b, 9d kronenförmige Erhebungen ausgebildet, die den Preßkontakt mit den Löthöckern (z.B. Löthöcker 26 in Figur 3) verbessern.

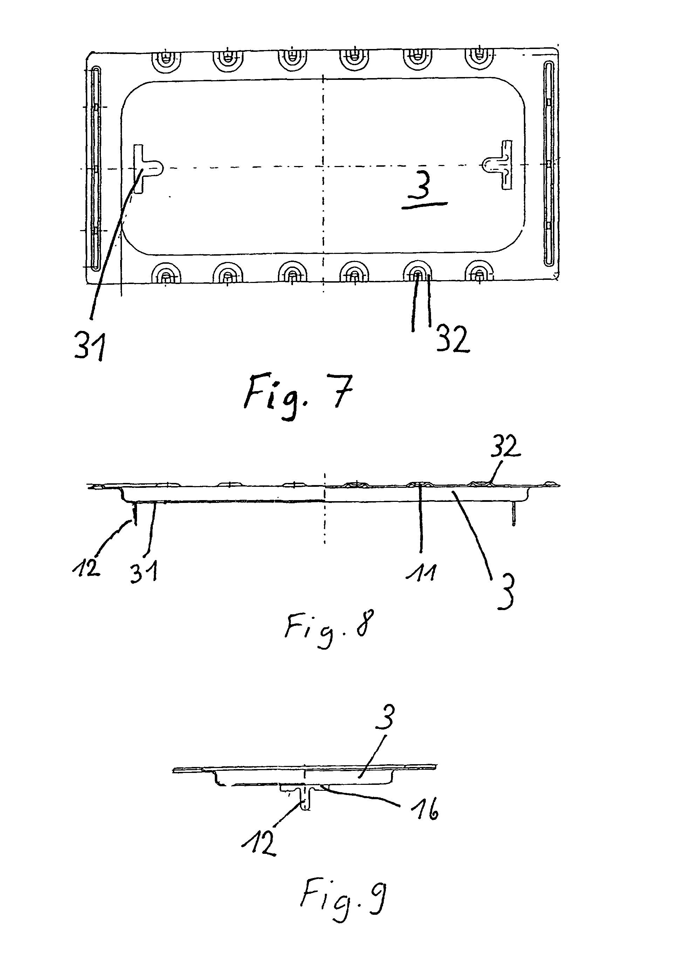

In Figur 7 ist der Schirmgehäusedeckel 3 als tiefgezogenes Stanzbiegeteil ausgeführt und weist Öffnungen 11 zum Durchstecken der Biegelaschen 9a, 9b, 9c, 9d auf. Um die Öffnungen 11 sind Erhebungen 32 angeordnet, die einen guten Kontakt zu Löthöckern (z.B. 27 in Figur 3) herstellen.

Weiterhin weist der Schirmgehäusedeckel 3 zwei Öffnungen 31 auf, aus denen die Positionierhilfen 11, 12 ausgestanzt und umgebogen wurden.

In Figur 8 erkennt man die Positionierhilfen 12, die Öffnungen 11, 31 und die Erhebungen 32.

In Figur 9 weist die Positionierhilfe einen breiteren Teil 16 auf, der mit seiner Unterseite auf einer Grundplatte oder anderen Leiterplatte nach der Montage des erfindungsgemäßen Schaltkreises auf einer Grundplatte oder anderen Leiterplatte aufliegt.

## Patentansprüche

1. Elektronischer Schaltkreis bestehend aus elektrischen und/oder elektronischen Bauelementen (5, 6, 7, 29) und deren Verbindungsleitungen (4, 20) auf einer Leiterplatte (1), wobei ein Schirmgehäuse bestehend aus einer Schirmgehäusedose (2) und einem Schirmgehäusedeckel (3) den elektronischen Schaltkreis zur Verhinderung von Störungen, die auf den elektronischen Schaltkreis einwirken, die durch den elektronischen Schaltkreis hervorgerufen werden, hochfrequenzbedämpfend umschließt, wobei der Schaltkreis auf der Leiterplatte (1) nach außen führende Anschlußleitungen (4, 20) aufweist, wobei die Anschlußleitungen (4, 20) des elektronischen Schaltkreises auf der Leiterplatte (1) aus dem Schirmgehäuse geführt und Anschlußmittel (8) außerhalb des Schirmgehäuses (2,3) mit den Anschlußleitungen (4,20) verbunden sind, und Abschirmmittel (5, 29) vorhanden sind, die den Eintritt von hochfrequenten Störungen in das Schirmgehäuse und den Austritt von hochfrequenten Störungen aus dem Schirmgehäuse reduzieren oder unterdrücken, insbesondere zur Verwendung in einem Kombinationsanzeigeinstrument eines Kraftfahrzeuges, wobei der Schirmgehäusedeckel (3) derart ausgebildet ist, daß die Leiterplatte (1) beidseitig mit elektrischen und elektronischen Bauteilen (5, 6, 7, 29) bestückbar ist,
**dadurch gekennzeichnet, daß** das Schirmgehäuse (2, 3) Positionierhilfen (12) zum Positionieren des Schaltkreises auf einer Grundplatte aufweist.

2. Elektronischer Schaltkreis nach Anspruch 1, **dadurch gekennzeichnet, daß** die Positionierhilfen (12) zur Abstützung des Schaltkreises auf der Grundplatte ausgestaltet sind.

3. Elektronischer Schaltkreis nach einem der vorhergehenden Ansprüche, **dadurch gekennzeichnet, daß** der Schirmgehäusedeckel (3) tiefgezogen ist.

4. Elektronischer Schaltkreis nach einem der vorstehenden Ansprüche, **dadurch gekennzeichnet, daß** die Anschlußmittel (8) gleichzeitig mit Anschlußleitungen (4, 20) auf der Oberseite und der Unterseite der Leiterplatte verbunden sind.

5. Elektronischer Schaltkreis nach einem der vorstehenden Ansprüche, **dadurch gekennzeichnet, daß** die Anschlußmittel (8) als Gull-Wing-Anschlüsse zur Oberflächenmontage des elektronischen Schaltkreises auf der Grundplatte (14) ausgebildet sind.

6. Elektronischer Schaltkreis nach einem der vorstehenden Ansprüche, **dadurch gekennzeichnet, daß** die Abschirmmittel derart ausgestaltet sind, daß auf der Leiterplatte Kontaktmittel (26, 27) vorhanden sind, die elektrisch leitend mit dem Schirmgehäuse (2, 3) verbunden sind, daß Kondensatoren (5, 29) die Anschlußleitungen (4, 20) des elektronischen Schaltkreises und die Kontaktmittel innerhalb des Schirmgehäuses wechselstrommäßig verbinden.

7. Elektronischer Schaltkreis nach Anspruch 6 **dadurch gekennzeichnet, daß** die Verbindung zwischen den Kontaktmitteln und dem Schirmgehäuse durch Druckkontakte ausgeführt sind.

## Claims

1. Electronic circuit composed of electrical and/or electronic components (5, 6, 7, 29) and their connecting lines (4, 20) on a printed circuit board (1), wherein a screened housing composed of a screened housing socket (2) and a screened housing lid (3) surrounds the electronic circuit with a high-frequency-damping effect in order to prevent interference which acts on the electronic circuit and is caused by the electronic circuit, wherein the circuit on the printed circuit board (1) has outwardly leading connecting lines (4, 20), wherein the connecting lines (4, 20) of the electronic circuit on the printed circuit board (1) are led out of the screened housing, and connecting means (8) are connected to the connecting lines (4, 20) outside the screened housing (2, 3), and screening means (5, 29) are provided which reduce or suppress the entry of radiofrequency interference into the screened housing and the exit of radiofrequency interference from the screened housing, in particular for use in a combination display instrument of a motor vehicle, wherein the screened housing lid (3) is embodied in such a way that the printed circuit board (1) can be equipped with electrical and electronic components (5, 6, 7, 29) on both sides, **characterized in that** the screened housing (2, 3) has positioning aids (12) for positioning the circuit on a base plate.

2. Electronic circuit according to Claim 1, **characterized in that** the positioning aids (12) are configured so as to support the circuit on the base plate.

3. Electronic circuit according to one of the preceding claims, **characterized in that** the screened housing lid (3) is deep-drawn.

4. Electronic circuit according to one of the preceding claims, **characterized in that** the connecting means (8) are simultaneously connected to connecting lines (4, 20) on the upper side and on the lower side of the printed circuit board.

5. Electronic circuit according to one of the preceding claims, **characterized in that** the connecting means (8) are embodied as gull wing connections for surface mounting the electronic circuit on the base plate (14).

6. Electronic circuit according to one of the preceding claims, **characterized in that** the screening means are configured in such a way that contact means (26, 27) which are connected to the screened housing (2, 3) in an electrically conductive fashion are provided on the printed circuit board, **in that** capacitors (5, 29) form an alternating current connection between the connecting lines (4, 20) of the electronic circuit and the contacting means within the screened housing.

7. Electronic circuit according to Claim 6, **characterized in that** the connection between the contact means and the screened housing is made by means of press-in contacts.

## Revendications

1. Circuit de commutation électronique composé de composants électriques et / ou électroniques (5, 6, 7, 29) et de leurs conducteurs de raccordement (4, 20) sur une carte à circuits imprimés (1), où un boîtier écran, composé d'une boîte écran (2) et d'un couvercle (3), entoure, en affaiblissant les hautes fréquences, le circuit de commutation électronique pour éviter des perturbations, qui agissent sur le circuit de commutation électronique et qui sont générées par le circuit de commutation électronique, où le circuit de commutation comporte, sur la carte à circuits imprimés (1), des conducteurs de raccordement (4, 20) conduisant vers l'extérieur, où les conducteurs de raccordement (4, 20) du circuit de commutation électronique sur la carte à circuits imprimés (1) conduisent hors du boîtier écran et où des moyens de raccordement (8) se trouvant hors du boîtier écran (2, 3) sont reliés aux conducteurs de raccordement (4, 20) et où il y a des moyens de blindage (5, 29), qui réduisent ou suppriment l'entrée de perturbations hautes fréquences dans le boîtier écran et la sortie de perturbations hautes fréquences hors du boîtier écran, destiné, notamment, à être utilisé dans un instrument combiné dans un véhicule automobile, le couvercle (3) du boîtier écran étant conçu de telle manière que la carte à circuits imprimés (1) peut être équipée des deux côtés avec des composants électriques et électroniques (5, 6, 7, 29), **caractérisé par le fait que** le boîtier écran (2, 3), comporte des aides au positionnement (12) pour la mise en place du circuit de commutation sur une plaque de base.

2. Circuit de commutation électronique selon la revendication 1 **caractérisé par le fait que** les aides au positionnement (12) sont conçues pour supporter le circuit de commutation sur la plaque de base.

3. Circuit de commutation électronique selon l'une des revendications précédentes **caractérisé par le fait que** le couvercle (3) du boîtier écran est une pièce emboutie.

4. Circuit de commutation électronique selon l'une des revendications précédentes **caractérisé par le fait que** les moyens de raccordement (8) sont reliés à des conducteurs de raccordement (4, 20) aussi bien sur la face supérieure que sur la face inférieure de la carte à circuits imprimés.

5. Circuit de commutation électronique selon l'une des revendications précédentes **caractérisé par le fait que** les moyens de raccordement (8) sont conçus sous la forme de broches Gull-Wing pour le montage en surface du circuit de commutation électronique sur la plaque de base (14).

6. Circuit de commutation électronique selon l'une des revendications précédentes **caractérisé par le fait que** les moyens de blindage sont conçus de telle manière qu'il y a, sur la carte à circuits imprimés, des moyens de contact (26, 27) reliés électriquement au boîtier écran (2, 3), que des condensateurs (5, 29) relient en courant alternatif les conducteurs de raccordement (4, 20) du circuit de commutation électronique et les moyens de contact à l'intérieur du boîtier écran.

7. Circuit de commutation électronique selon la revendication 6 **caractérisé par le fait que** la liaison entre les moyens de contact et le boîtier écran est réalisée par des contacts à pression.
